# EUROPEAN PATENT SPECIFICATION

(11) **EP 2 762 604 B1**
(45) Date of publication and mention of the grant of the patent: **01.04.2020**
(21) Application number: 11838997.2
(22) Date of filing: 30.09.2011
(51) Int. Cl.: C23C 14/02, C23C 14/22, C23C 14/54, B05D 1/00, C23C 14/06

(54) **FILM FORMING METHOD AND FILM FORMING APPARATUS**
FILMBILDUNGSVERFAHREN UND FILMBILDUNGSVORRICHTUNG
PROCÉDÉ DE FORMATION DE FILM ET APPAREIL DE FORMATION DE FILM

(43) Date of publication of application: 06.08.2014
(73) Proprietor: Shincron Co., Ltd., Kanagawa 220-8680 (JP)
(72) Inventor: SHIONO, Ichiro, Yokohama-shi Kanagawa 220-8680 (JP); MIYAUCHI, Mitsuhiro, Yokohama-shi Kanagawa 220-8680 (JP); JIANG, Yousong, Yokohama-shi Kanagawa 220-8680 (JP)
(74) Representative: Strehl Schübel-Hopf & Partner
(86) International application number: PCT/JP2011/072586
(87) International publication number: WO 2013/046440

(56) References cited:
- WO-A1-2010/026887
- JP-A- 2010 090 454
- JP-A- 2010 106 339
- JP-A- 2010 106 339
- JP-A- 2010 242 174
- US-A1- 2003 077 401

## Description

### TECHNICAL FIELD

The present invention relates to a method for depositing a film and a film deposition system particularly suitable for depositing an oil repellent film.

### BACKGOUND ART

There is known a technique of depositing an oil repellent film on a surface of a substrate through a procedure explained below (patent document 1). The method is to hold a plurality of substrates to be processed on the whole surface of a substrate holding surface of a substrate holder and, then, to rotate the substrate holder in a vacuum chamber. Next, in a state of maintaining the rotation, ions are continuously irradiated to all of the substrates (whole surface ion irradiation) and, subsequently, toward all of the substrates having asperity surfaces formed by the ion irradiation, a film forming material composed of materials for forming an oil repellent film is evaporated to adhere. This is the method of depositing an oil repellent film on the asperated surfaces of all of the substrates by the procedure above.

### RELATED ART DOCUMENTS

### Patent Document

Patent Document 1: Japanese Patent Unexamined Publication (Kokai) No. 2010-90454
Patent Document 2: JP2010106339

### SUMMARY OF THE DISCLOSED SUBJECT MATTER

According to the conventional method explained above, an oil repellent film having abrasion resistance enough for practical use can be formed on a substrate (paragraph [0029] in the patent document 1), however, in recent years, there have been demands for further improvements of abrasion resistance of oil repellent films.

According to an aspect of the present invention, there is provided a method of depositing a film and a film deposition system, by which oil repellent films having improved abrasion resistant properties, not to mention being good enough for practical use, can be deposited efficiently.

According to the present invention, there is provided a method for depositing a film as disclosed in claim 1, comprising the steps of irradiating ions to a partial region (for example A2) of a base holding surface of a base holding means, thereby, the ions are irradiated only to a certain base group (partial ion irradiation) fed to the region (A2) among a plurality of bases held on the base holding surface and rotating; and subsequently, in a state of suspending irradiation of the ions, supplying a film deposition material of an oil repellent film to all the bases by supplying the film deposition material to the whole region (for example, A1) on the base holding surface; for depositing an oil repellent film on surfaces of the bases.

In the present invention, when time of supplying a film deposition material is T1 and irradiation time of ions is T2, ions can be irradiated so as to satisfy T2≤((1/2)×T1) for each base. Partial ion irradiation as such can be realized, for example, by suitably adjusting at least either one of a rotation speed of the base holding means and an ion irradiation region (for example, A2) .

In the present invention, when a region supplied with a film deposition material is A1 and ion irradiation region is A2, ions can be irradiated to a base holding surface of a base holding means so as to satisfy A2≤((1/2)×A1). In that case, more preferably, ions are irradiated so that an irradiation region becomes a region surrounded by a longitudinal closed curve along a moving direction of the bases.

In the present invention, ions having an accelerating voltage of 50V to 1500V may be used and/or ions having an irradiation ion current of 50mA to 1500mA may be used. In the present invention, ions containing at least oxygen may be used.

According to the present invention, there is provided a film deposition system according to claim 8, for depositing an oil repellent film wherein a base holding means having a base holding surface for holding a plurality of bases is provided rotatably in a vacuum container, comprising:
an ion irradiation means provided to inside the vacuum container to have a configuration and in an arrangement and/or a direction, by which ions can be irradiated to a partial region (for example A2) on the base holding surface; and
a film deposition means provided in the vacuum container in an arrangement and direction, by which a film deposition material can be supplied to allover the base holding surface;
wherein an operation of the ion irradiation means is stopped before starting an operation of the film deposition means.

In the present invention, the ion irradiation means may be provided to inside the vacuum container in an arrangement, by which ions can be irradiated half or less of the whole region of the base holding surface.

In the present invention, a rotation means for rotating the base holding means is furthermore provided, and the ion irradiation means may be provided to inside the vacuum container so that an axis line of irradiating ions from the ion irradiation means forms an angle of 6° or larger and 70° or smaller with respect to an axis line of rotation of the base holding means.

In the present invention, the ion irradiation means may be provided on a side surface side of the vacuum container, and the ion irradiation means may be provided so that a distance from the substrates to be held on the base holding surface to the ion irradiation means becomes a mean free path or shorter at the time of film deposition.

In the present invention, the ion irradiation means may be attached to a side surface of the vacuum container via a supporting means which can adjust at least the attaching angle.

In the present invention, the substrate holding means has a plate shape, dome shape or a pyramid shape, wherein a through hole penetrating from one side to the other side is formed, and substrates to be held on the substrate holding surface at film deposition may be held on the base holding means so as to cover the through hole.

In the present invention, a heating means for heating the bases and the base holding means may be furthermore provided.

According to the present invention, before depositing an oil repellent film on surfaces of a plurality of bases held on a base holding surface of a base holding means and rotating (before starting film deposition), by irradiating ions to a partial region on the base holding surface of the base holding means, ions are irradiated only on a certain base group fed to the region among the plurality of bases held on the base holding surface and rotating (partial ion irradiation).

According to the present invention, comparing with the conventional method of using whole-surface ion irradiation of irradiating ions to all of a plurality of bases held on a base holding surface and rotating before starting film deposition, it was found that a bonding force between bases and thin films to be deposited thereon is enhanced, consequently, abrasion resistance of the thin films is furthermore improved comparing with that in the conventional method.

The reason why the abrasion resistance of the thin films improves when using the method of the present invention is not all clear. It is considered that as a result of performing ion irradiation only on a partial region of the rotating base holding means, time when ions are not irradiated is secured for each base. It is assumed that during the time without ion irradiation, base surface atoms, which became energetically unstable due to ion etching, return to a stable state or rearranged to be at stable surface atom positions, which results in an improvement of a bonding force of atoms and molecules of a thin film deposited on an aspirated surface of a base with the base surface atoms and enhancement of abrasion resistance.

### BRIEF EXPLANATION OF THE DRAWINGS

[FIG. 1] FIG. 1 is a sectional view seen from the front of a film deposition system according to an embodiment of the present invention.
[FIG. 2] FIG. 2 is a sectional view along the II-II line in FIG. 1.
[FIG. 3] FIG. 3 is a sectional view showing another embodiment corresponding to FIG. 2.
[FIG. 4] FIG. 4 is a schematic diagram of an irradiation region of an ion beam on a substrate holder in terms of their positional relationship in an example 1 (example).
[FIG. 5] FIG. 5 is a schematic diagram of an irradiation region of an ion beam on a substrate holder in terms of their positional relationship in an example 2 (comparative example).

### DESCRIPTION OF NUMERICAL NOTATIONS

1... film deposition system, 10... vacuum container, 12... substrate holder (base holding means), 14... substrate (base), 34... deposition source (film deposition means), 34a and 38a... shutters, 34b... crucible, 38... ion source (ion irradiation means), 38b... adjustment wall, 44... attachment (supporting means), 50... crystal monitor, 51... film thickness detection unit, 52... controller, 53... electrical heater, 54... temperature sensor

### EXEMPLARY MODE FOR CARRYING OUT THE DISLCOSED SUBJECT MATTER

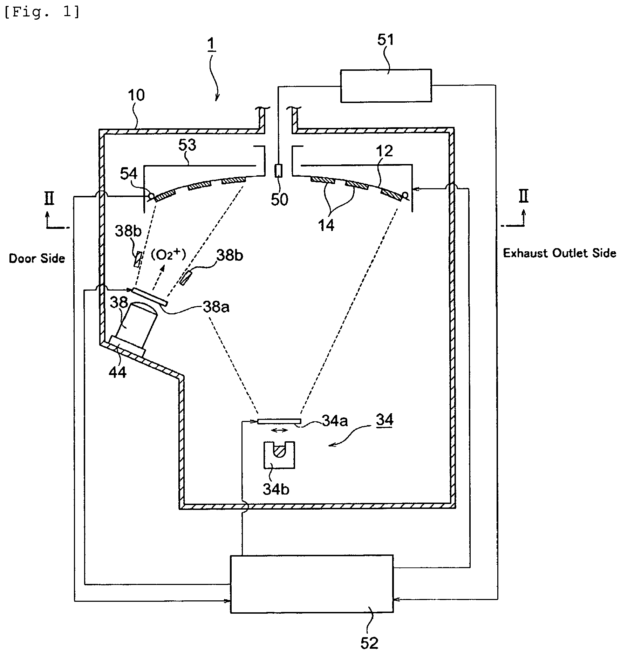

Below, embodiments of the invention above will be explained based on the drawings. As shown in FIG. 1, a film deposition system 1 of the present embodiment comprises an upright cylindrical vacuum container 10.

The vacuum container 10 is a stainless-steel container having an approximate cylindrical shape, which is normally used in well-known film deposition systems, and is at a ground potential. The vacuum container 10 is provided with an exhaust outlet (not shown. on the right side in FIG. 1 in the present embodiment), and a vacuum pomp (not shown) is connected through the exhaust outlet. When the vacuum pomp is activated, inside the vacuum container 10 is exhausted to have a predetermined pressure (for example, 10⁻⁴ Pa to 3×10⁻² Pa or so). A gas introduction pipe (not shown) for introducing a gas to the inside is formed in the vacuum container 10. A load lock chamber (not shown) may be connected to the vacuum container 10 through a door (not shown. on the left side in FIG. 1 in the present embodiment).

A substrate holder 12 is held at an upper part inside the vacuum container 10. The substrate holder 12 (base holding means) is a stainless-steel member formed to be a dome shape, held to be rotatable about a vertical axis, and connected to an output axis (not shown rotation means) of a motor (not shown rotation means).

On a lower surface (the base holding surface) of the substrate holder 12, a plurality of substrates 14 are supported when depositing a film. An opening is provided at the center of the substrate holder 12 in the present embodiment, where a crystal monitor 50 is provided. The crystal monitor 50 detects a physical thickness of a film deposited on the substrate 14 surface with a film thickness detection unit 51 from changes of a resonance frequency caused by adhesion of deposition substances (evaporated substances of a film deposition material) to its surface. The detection result of the film thickness is sent to a controller 52.

At an upper portion inside the vacuum container 10, an electric heater 53 (heating means) is provided so as to cover the substrate holder 12 from above. A temperature of the substrate holder 12 is detected by a temperature sensor 54, such as a thermocouple, and the result is sent to the controller 52.

Based on the output from the film thickness detection unit 51, the controller 52 controls an open/close state of a shutter 34a of a deposition source 34 and a shutter 38a of an ion source 38, which will be explained later on, and suitably controls a thickness of the thin film to be formed on the substrate 14. Also, the controller 52 controls the electric heater 53 and regulates a temperature of the substrate 14 to be appropriate based on the output from the temperature sensor 54. The controller 52 also controls start and stop of operations of the ion source 38 and the deposition source 34, which will be explained later on.

The deposition source 34 is provided at a lower portion inside the vacuum container 10. The deposition source 34 (film deposition means) is resistance heating (direct heating and indirect heating, etc.) deposition source. The deposition source 34 comprises a crucible (boat) 34b having a concave for carrying a film deposition material on its top and an openable and closable shutter 34a provided at a position of blocking the film deposition material flowing from the crucible 34b to the substrates 14. Opening/closing of the shutter 34a is suitably controlled by an instruction from the controller 52.

In direct heating, electrodes are attached to a metal boat to apply a current and the metal boat is heated directly, so that the boat itself becomes a resistance heater and the film deposition material contained therein is heated. In indirect heating, the boat is not a direct heat source and a heating device is provided separately from the boat. It is a method of heating by applying a current to a deposition filament, for example, made by a transition metal or other rare metal, etc.

In a state of carrying the film deposition material in the crucible 34b, the film deposition material is heated by the boat itself or by the heating device provided separately, and when the shutter 34a opens in this state, the film deposition material evaporating from the crucible 34b moves inside the vacuum container 10 toward substrates 14 and adheres to surfaces of the respective substrates 14.

Note that the deposition source 34 is not limited to the resistance heating and may be an electron beam heating type deposition source. When the deposition source 34 is an electron beam heating type, the deposition source 34 may further comprise an electron gun for irradiating an electron beam (e⁻) to the film deposition material to evaporate the same and an electron gun power source (both not shown) in addition to the crucible 34b and the shutter 34a as explained above.

In the present embodiment, the deposition source 34 is provided in an arrangement and a direction of allowing the film deposition material to adhere continuously to all substrates 14 held by the substrate holder 12 rotating about the vertical axis in response to an output from a motor.

In the present embodiment, an ion source 38 is provided on the side surface side inside the vacuum container 10. However, the position of attaching the ion source 38 is not limited to the side surface inside the vacuum container 10 in the present invention, and the ion source 38 (ion irradiation means) of the present embodiment is an ion irradiation apparatus used only for the purpose of irradiating an ion beam to the substrates 14 before operating the deposition source 34.

The ion source 38 is for drawing positively-charged ions (O₂⁺, Ar⁺) from plasma of a reaction gas (for example, O₂) or a noble gas (for example, Ar), accelerating by an accelerating voltage and inject to the substrates 14 to perform an ion cleaning treatment on the substrate 14 surfaces before starting film deposition. Above the ion source 38, an openable and closable shutter 38a is provided at a position of blocking an ion beam from the ion source 38 to the substrates 14. Opening/closing of the shutter 38a is suitably controlled by an instruction from the controller 52

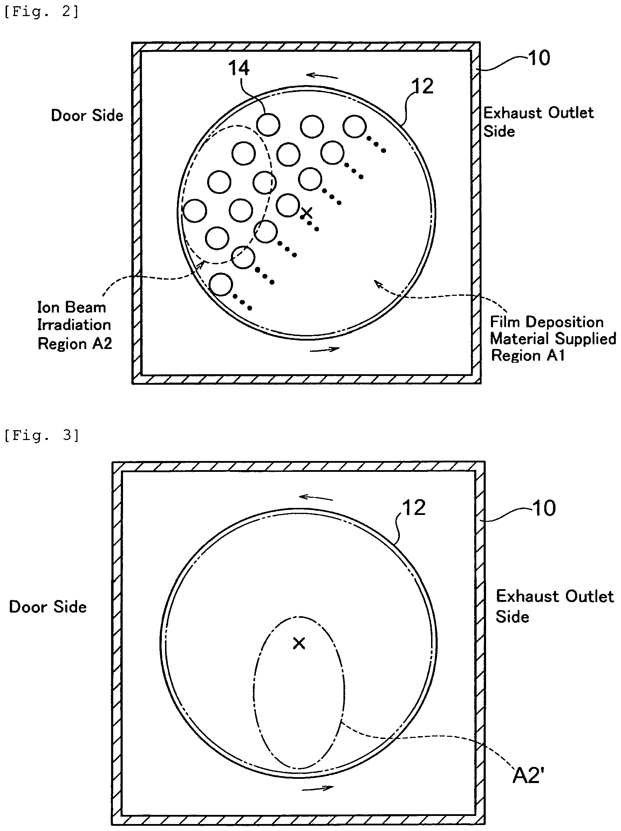

The ion source 38 of the present embodiment is provided in an arrangement and/or a direction to have a configuration (for example, a curvature of the electrodes) of allowing an ion beam to partially irradiate to a part of the substrates 14 held by the substrate holder 12 rotating about a vertical axis in response to an output from the motor. Specifically, for example, as shown in FIG. 2, the ion source 38 is provided so that the ion beam can be irradiated to a part of the substrate holder 12 in rotation, that is, a part of all the substrates 14 (a certain group of the substrates 14 fed to a region A2 surrounded by a dashed line). As long as an ion beam can be irradiated as such, the position of attaching the ion source 38 is not limited to the side surface inside the vacuum container 10.

Namely, the ion source 38 is arranged so that the ion beam irradiation region (A2) becomes smaller than a region where a film deposition material is supplied from the deposition source 34 (the region A1 surrounded by an alternate one-long and two-short dashed line in FIG. 2) (A2<A1). In the present embodiment, it is particularly preferable that A2≤((1/2)×A1) is satisfied when arranging the ion source 38.

By arranging the ion source 38 as above, the ion beam irradiated from the ion source 38 is irradiated to a part of the all substrates 14 held by the substrate holder 12 and rotating and, specifically, only to a certain group of the substrates 14 fed to the region A2. Note that, by continuing the partial ion irradiation of the present embodiment for a predetermined time, eventually, the ion beam can be irradiated to all of the substrates 14 held by the substrate holder 12 and rotating.

The ion source 38 may be also arranged, so that the ion beam can be irradiated, for example, to a region A2' surrounded by an alternate one-short and one-long dashed line shown in FIG. 3. However, in the embodiment in FIG. 3, ion beam irradiation time may differ relatively between certain substrates 14 held near the rotation axis of the substrate holder 12 (refer to "×" in the figure) and other substrates 14 held close to the outer circumference of the substrate holder 12 in some cases. In that case, characteristics of the all substrates 14 held by the substrate holder 12 may not be uniform. Accordingly, in the present embodiment, as shown in FIG. 2, it is preferable to arrange the ion source 38 so that the ion beam can be irradiated to a region surrounded by a vertically long closed curve (for example, approximate oval) along the moving direction of the substrates 14.

Going back to FIG. 1, in the present embodiment, adjustment walls 38b and 38b for adjusting directionality of ions drawn from the ion source 38 may be provided above the shutter 38a. By providing them, the ion beam can be irradiated to a predetermined region (for example, the region A2 in FIG. 2 and a region A2' in FIG. 3, etc.) on the substrate holder 12 regardless of the arrangement of the ion source 38 explained above.

The ion source 38 of the present embodiment is attached to the side surface of the vacuum container 10 via an attachment 44 as a supporting device.

By attaching the ion source 38 to the side surface side of the vacuum container 10, as same as the deposition source 34, comparing with the case of providing it at a lower portion inside the vacuum container 10, the ion beam irradiated from the ion source 38 can reach the substrates with a short travel distance. As a result, it is possible to prevent a decline of ion kinetic energy at colliding with the substrates 14.

Also, it is considered that as a result of bringing the ion beam in a state of keeping high kinetic energy collide with surfaces of the substrates 14 from an oblique direction, the ion cleaning effects on the surfaces of the substrates 14 can be furthermore developed; and as a result that impurity atoms on the substrate surfaces can be removed effectively, bonding between atoms on the surfaces of the substrates 14 and oil repellent molecules is accelerated and abrasion resistance properties of an oil repellent film to be deposited thereon improves.

The ion source 38 of the present embodiment is arranged at a closer position to the substrates 14 than the position of arranging the deposition source 34 by a body length of the ion source 38 or longer. Also, a part of the side surface of the vacuum container 10 is formed to be a slope for facilitating attachment of the ion source 38, but a position of attaching the ion source 38 is arbitrary.

Note that a position of attaching the ion source 38 is not limited to the side surface of the vacuum container 10 and may be at a lower portion inside the vacuum container 10 as same as the deposition source 34. In any case, it is attached to a position at which the ion beam can be irradiated to a part of the substrates 14 held on the substrate holder 12.

The attachment 44 (supporting means) is a supporting device for the ion source 38 and attached to the side surface of the vacuum container 10. The attachment 44 comprises a bracket (not shown) fixed to the vacuum container 10 side, a supporting pin (not shown) for allowing the ion source 38 side to be inclined with respect to the bracket, and a braking member (not shown) formed by a screw for fixing the inclination of the ion source 38 at a predetermined position. Due to this, an angle of attaching the ion source 38 can be adjusted freely. Also, by providing the bracket to the vacuum container 10 side and fixing the same to a base plate (not shown), a position of which can be adjusted, it is configured that not only the attachment angle but a position in the height direction and in the radius direction can be adjusted. Note that adjustment of a position in the height direction and the radius direction is made by moving the base plate in the vertical direction and in the radius direction.

By changing an attaching height "h" and a position in the radius direction of the ion source 38, a distance between the ion source 38 and the substrates 14 can be adjusted to be appropriate, and an incident angle and position of the ion beam which collides with the substrates 14 can be adjusted by changing the attaching angle. By adjusting a position in the height direction and radius direction of the ion source 38 and an angle of attaching, a loss of the ion beam is suppressed to the minimum and a distribution of ion current density becomes uniform on the irradiation region (for example, A2 in FIG. 2 and A2' in FIG. 3) of the ion source 38.

The attaching angle θ of the ion source 38 is an angle formed by an axis line of irradiating the ion beam and a rotation axis line of the substrate holder 12. When the angle is too large or too small, the effects of substrate cleaning by the ion beam irradiation decreases and it is liable that the effect of improving abrasion resistance of an oil repellent film is deteriorated or lost.

In the present embodiment, when the attaching angle θ is in a range of 6° to 70°, after the partial ion irradiation, it is possible to obtain the effect of furthermore improving the abrasion resistance of the oil repellent film to be deposited by supplying a film deposition material to the whole surface as will be explained later.

Also, as long as the ion beam from the ion source 38 is in a reachable range to the substrates 14, a method of irradiating the ion beam from an oblique direction to the surfaces of the substrates 14 does not depend on a distance between the substrates 14 and the ion source 38.

Note that the attaching angle θ above can be naturally changed to be appropriate depending on sizes of the substrate holder 12 and the vacuum container 10 and a film deposition material.

The attachment height "h" is set, so that the distance between the ion source 38 and the substrates 14 becomes appropriate. When the attachment height "h" is too high, the attaching angle θ becomes too large, while when the attaching height "h" is too low, a distance between the substrates 14 and the ion source 38 becomes long and the attaching angle θ becomes too small. Accordingly, the attaching height "h" has to be at a position by which an appropriate attaching angle θ can be obtained.

The distance between the ion source 38 and the substrates 14 is preferably equal to or shorter than a mean free path 1. For example, when the mean free path 1 = 500mm, it is preferable that the distance between the ion source 38 and the substrates 14 is also 500mm or shorter. When the distance between the ion source 38 and the substrates 14 is equal to or shorter than the mean free path 1, a half or more ions discharged from the ion source 38 in a collision-free state can be brought to collide with the substrates 14. Since the ion beam can be irradiated to the substrates 14 while keeping high energy, the effect of improving abrasion resistance of an oil repellent film deposited subsequently by being supplied a film deposition material allover the surface is great.

Here, "a distance between the ion source 38 and the substrates 14" means a distance from a center of the ion source 38 to the center of the film depositing surface side of the substrate holder 12. In the same way, "a distance from the deposition source 34 and the substrates 14" means a distance from a center of the deposition source 34 to the center of the film deposition surface side of the substrate holder 12. Also, "a body length of the ion source 38" means a distance from the electrodes of the ion source 38 (ion gun) to the bottom of the ion plasma discharge chamber.

An attachment position of the ion source 38 is not limited to a position on the side surface side of the vacuum container 10 and may be a position away from a wall surface of the side surface of the vacuum container 10 by using the attachment 44. The attachment 44 can adjust a position of the ion source 38 also in the radius direction, so that an arrangement as such can be attained easily. In that case, since the ion beam can be irradiated from a closer position to the substrates 14, the effects of the partial ion irradiation can be obtained even with a lower energy (power consumption).

Note that the ion source 38 may be provided on the bottom. In that case, the ion source 38 may be attached on a base provided on the bottom.

Also, when the ion source 38 is attached on the side surface of the vacuum container 10, a film thickness correcting plate (not shown) provided between the deposition source 34 and the substrates does not hinder the ion beam and a loss of ions decreases thereby, which is preferable.

According to the film deposition system 1 according to the present embodiment, the ion source 38 is provided at an arrangement by which partial irradiation of the ion beam becomes possible. Specifically, the ion source 38 is arranged so that an irradiation region A2 by the ion beam from the ion source 38 becomes smaller than a region A1 to which a film deposition material is supplied from the deposition source 34 (A2<A1).

By using the film deposition system 1 configured as above, an ion beam can be irradiated to a partial region on the substrate holding surface of the substrate holder 12, consequently, the ion beam can be irradiated only to a certain group of substrates 14 fed to the region among the plurality of substrates 14 held by the substrate holder 12 and rotating (partial ion irradiation).

As a result, comparing with a conventional film deposition system configured that the ion beam irradiation region A2 is the whole surface of the substrate holder 12 as same as a film deposition material supplied region A1 (namely, irradiating on the whole substrate 14), the ion irradiation is performed only on a partial region of the substrate holder 12 in rotation, so that time when ions are not irradiated is secured for each of the substrates 14. During the time without ion irradiation, surface atoms of the substrates 14, which became energetically unstable due to ion etching, return to a stable state or rearranged at stable surface atom positions. As a result, a bonding force of atoms and molecules of thin films deposited on the asperated surfaces of the substrates 14 with surface atoms of the substrates 14 is improved and abrasion resistance of oil repellent films is furthermore enhanced. Particularly, by adjusting one or both of the rotation speed of the substrate holder 12 or the ion irradiation region so that A2 becomes a half of A1 or smaller (A2 ≤ ((1/2)×A1)), these effects can be brought out furthermore remarkably.

Next, an example of the film deposition method using the film deposition system 1 will be explained.

In the present embodiment, the mode of the film deposition material as a material of an oil repellent film filled in the boat of the deposition source 34 is not particularly limited and, for example, (a) those obtained by impregnating porous ceramic with a hydrophobic reactive organic compound and (b) those obtained by impregnating a bundle of metal fibers or thin lines with a hydrophobic reactive organic compound may be used. They can quickly absorb and evaporate a large amount of hydrophobic reactive organic compound. As to the porous ceramic, it is preferably used as pellets in terms of handleability.

As the metal fibers or thin lines, for example, iron, platinum, silver and copper, etc. may be mentioned. It is preferable that the metal fibers or thin lines are preferably in a tangled shape, for example, woven cloth or unwoven cloth so that it can hold a sufficient amount of hydrophobic reactive organic compound. A porosity of the metal fiber or fine line bundle may be determined depending on how much amount of the hydrophobic reactive organic compound to hold.

As the film deposition material, when using a bundle of metal fibers or fine lines, it is preferable to keep it in a container having an open end. The metal fiber or fine line bundle kept in a container can be considered equivalent to pellets. A shape of the container is not particularly limited and a Knudsen shape, divergent nozzle shape, cylindrical shape, divergent cylindrical shape, boat shape, and filament shape, etc. may be mentioned and may be selected suitably depending on specification of the film deposition system 1. At least one end of the container is open and a hydrophobic reactive organic compound can evaporate from the open end. As a material of the container, copper, tungsten, tantalum, molybdenum, nickel and other metals, alumina and other ceramics, and carbon, etc. may be used and it is selected suitably depending on the deposition apparatus and the hydrophobic reactive organic compound.

Neither of porous ceramic pellets nor pellets formed by a bundle of metal fibers or fine lines kept in a container is limited in size.

When impregnating the porous ceramic or metal fiber or fine line bundle with a hydrophobic reactive organic compound, an organic solvent solution of a hydrophobic reactive organic compound is prepared first, the solution is impregnated in porous ceramic, metal fibers or thin lines by using an immersion method, instillation method or spray method, etc., then, the organic solvent volatilizes. Since a hydrophobic reactive organic compound has a reactive group (hydrolytic group), an inert organic solvent is preferably used.

As an inert organic solvent, fluoro-modified aliphatic hydrocarbon-type solvents (perfluoroheptane and perfluorooctane, etc.), fluoro-modified aromatic hydrocarbon-type solvents (m-xylene hexafluoride and benzotrifluoride, etc.), fluoro-modified ether-type solvents (methyl perfluoro butyl ether and perfluoro(2-butyltetrahydrofuran), etc.), fluoro-modified alkylamine-type solvents (perfluorotributylamine and perfluorotripentylamine, etc.), hydrocarbon-type solvents (toluene and xylene, etc.) and ketone-type solvents (acetone, methyl ethyl ketone and methyl isobutyl ketone, etc.), etc. may be mentioned. These organic solvents may be used alone or two or more kinds may be mixed. Concentration of the hydrophobic reactive organic compound solvent is not limited and may be set suitably depending on a form of a carrier to be impregnated with the hydrophobic reactive organic compound.

Note that in the present embodiment, heating of the film deposition material is not limited to the resistance heating, and a halogen lamp, sheathed heater, electronic beam, plasma electronic beam and induction heating, etc. may be used, as well.
(1) First, on a lower surface of the substrate holder 12, a plurality of substrates 14 are set in a state where film deposition surfaces thereof face downward. The substrates 14 (bases) to be set on the substrate holder 12 may be configured by a glass, plastic and metal, for example, processed to have a plate shape or lens shape, etc. Note that preferably the substrates 14 are wet cleaned before or after being fixed.
(2) Next, after setting the substrate holder 12 inside the vacuum container 10, the inside of the vacuum container 10 is evacuated to, for example, 10⁻⁴ to 10⁻²Pa or so. When the vacuum is lower than 10⁻⁴Pa, vacuum evacuation takes too long and the productivity may be decreased. On the other hand, when the vacuum is higher than 10⁻²Pa, film deposition becomes insufficient in some cases and it is liable that the film properties deteriorate.
(3) Next, a current is applied to the electric heater 53 to heat and the substrate holder 12 is rotated at 5 to 60rpm and preferably at 10 to 40 rpm. Due to the rotation, a temperature and film deposition condition of the substrates 14 are unified.
   When the controller 52 determines that the temperature of the substrates became, for example, normal temperature to 120°C and preferably 50 to 90°C based on an output from the temperature sensor 54, it enters to a film deposition step. When the substrate temperature is lower than the normal temperature, it is liable that a density of a thin film to be deposited becomes low and sufficient film durability cannot be obtained. When the substrate temperature exceeds 120°C, in the case of using plastic substrates as the substrates 14, there is a possibility of causing deterioration and deformation of the substrates 14. Note that when using a material suitable to non-heating film deposition, the film deposition is sometimes performed at a normal temperature.
   In the present embodiment, before starting the film deposition step, the ion gun 38 is put in an idle operation state. Also, the deposition source 34 is put in preparation for diffusing (emitting) a film deposition material immediately in response to an opening operation of the shutter 34a.
(4) Next, the controller 52 increases irradiation electrical power (power) of the ion gun 38 from the idol state to a predetermined irradiation electrical power, the shutter 38a is opened and an ion beam is irradiated to surfaces of the respective substrates 14 in the middle of rotation. Namely, a step of irradiating an ion beam of an introduction gas (it is oxygen here) drawn from the ion gun 38 to the film deposition surfaces of the respective substrates 14 is performed. In the present embodiment, prior to depositing an oil repellent film, it is characterized that partial ion irradiation is performed only on a part of all the substrates held by the substrate holder 12 and revolving with the rotation of the substrate holder 12.
   A condition of the partial irradiation of the ion beam is as below.
   As gaseous species to be introduced to the ion gun 38, it is good if it includes at least argon or oxygen, it may be a mixture of argon and oxygen, and a mixed gas of argon and oxygen is preferable. An introduction amount of the gaseous species (a total introduction amount in the case of a mixture gas) is, for example, 1sccm or more, preferably 5sccm or more, more preferably 20sccm or more, also, for example, 100sccn or less, preferably 70sccm or less and more preferably 50sccm or less. The "sccm" is an abbreviation of "standard cc/m" and indicating that at 0°C and 101.3kPa (1 atmosphere).
   An accelerating voltage (V) of ions is, for example, 50 to 1500V, preferably 500 to 1300V and more preferably 700 to 1200V. An irradiation current (I) of ions is, for example, 50 to 1500mA, preferably 200 to 1300mA and more preferably 400 to 1200mA.
   Time (T1) of ion irradiation to the substrate holding surface of the substrate holder 12 is, for example, 1 to 800 seconds and preferably 10 to 100 seconds or so. When performing ion irradiation to the substrate holding surface of the substrate holder 12 for, for example, 600 seconds in the case of setting an ion irradiation region (A2) on the substrate holder 12 to be a half of a region (A1) supplied with a film deposition material from the deposition source 34, ions are irradiated only a half of the irradiation time (that is, T2 = 300 seconds) per one substrate 14 set on the substrate holding surface.
   In the present embodiment, as explained above, the ion source 38 is arranged in an arrangement by which partial irradiation of the ion beam becomes possible (A2 < A1). It is particularly preferable to irradiate the ion beam so as to satisfy T2≤((1/2)×T1) by arranging the ion source 38 to satisfy A2≤((1/2)×A1). Note that by arranging the ion source 38 so as to satisfy A2≤((1/2)×A1) and by changing a rotating speed of the substrate holder 12, it is also possible to irradiate the ion beam to satisfy T2≤((1/2)×T1). When irradiating the ion beam so as to satisfy T2≤((1/2)×T1), an improvement of a film quality of a thin film to be deposited on the surfaces of the substrates 14 is attained efficiently. "An improvement of a film quality" here is to improve abrasion resistance properties of an oil repellent film after deposition even when using a same oil repellent agent.
(5) Next, the controller 52 returns the irradiation electrical power of the ion gun 38 to an idle state, closes the shutter 38a, opens the shutter 34a and performs vacuum deposition using resistance heating of a film deposition material as a material for depositing an oil repellent film (film deposition processing). Namely, to the film deposition surfaces of the substrates 14 after partial irradiation of the ion beam by oblique irradiation, the film deposition processing is performed by diffusing the film deposition material from the deposition source 34 for, for example, 3 to 20 minutes. As a result, an oil repellent film is formed on a surface of each substrate 14 to be a predetermined thickness (for example, 1 to 50nm). The controller 52 keeps monitoring the film thickness of the thin film to be formed on the substrate 14 through the crystal monitor 50 and stops deposition when reaching to the predetermined thickness. Thereby, oil repellent films each having a predetermined film thickness can be deposited on the surfaces of the plurality of substrates 14 and oil repellent film substrates can be obtained.

According to a film deposition method using the film deposition system 1 according to the present embodiment, an ion beam is irradiated to a partial region of the substrate holding surface of the substrate holder 12, consequently, the ion beam is irradiated only to a certain group of substrates 14 fed to the region among the plurality of substrates 14 held by the substrate holder 12 and rotating (partial ion irradiation). As a result, the ion beam is partially irradiated so that the irradiation region A2 of the ion beam becomes smaller than the region A1 supplied with a film deposition material by the deposition source 34 (A2<A1).

As a result of performing the partial irradiation of ion beam by the ion source 38 before starting film deposition, comparing with the conventional technique of irradiating the ion beam to the whole surface before starting film deposition, time when ions are not irradiated is secured for each substrate 14 by performing ion irradiation only on a partial region of the substrate holder 12 in rotation. During the time without ion irradiation, surface atoms of the substrate 14 which became energetically unstable due to ion etching return to a stable state or rearranged at stable surface atom positions. Consequently, a bonding force of atoms and molecules of a thin film to be formed on an asperated surface of the substrate 14 with surface atoms of the substrate improves and abrasion resistance of the oil repellent film is furthermore enhanced. Particularly, effects as such can be brought out furthermore remarkably by adjusting one or both of a rotation speed of the substrate holder 12 and an irradiation region of ions, so that T2 becomes a half of T1 or shorter (T2≤((1/2)×T1).

Not to mention that the oil repellent film of the oil repellent film substrate obtained by the film deposition method of the present embodiment is good enough for practical use, the abrasion resistance is furthermore enhanced. Specifically, the oil repellent film has enhanced abrasion resistance, such that even after reciprocating steel wool #0000 for 1000 times (preferably 2000 times) with a load of 1kg/cm², it is possible to wipe off an ink by an oil pen.

Accordingly, the oil repellent film substrate obtained from the present embodiment can be preferably used for the use purpose requiring oil repellence, for example, a variety of displays (for example, a plasma display panel (PDP), cathode ray tube (CRT), liquid crystal display (LCD) and electroluminescence display (ELD), etc.); show cases; cover glasses of a clock and instrument; surfaces of touch panel type electronic devices, such as an ATM of banks and ticketing machine; and cellular phones, personal computers and other variety of electronic devices having various displays as above; etc.

Note that the film deposition procedure of the oil repellent film is not limited to the procedure above. For example, by arranging another deposition source (for example, electron beam heating type, etc.) besides the deposition source 34 at a lower portion inside the vacuum container 10, then, after cleaning the substrate 14 surfaces by oblique irradiation of an ion beam, depositing an inorganic film of SiO₂ or Al₂O₃, etc. having several nm or so on the cleaning surfaces of the all substrates 14 held by the substrate holder 12 by the separately arranged deposition source (illustration is omitted) and, then, activating the deposition source 34, an oil repellent film may be also deposited. Also from this mode, comparing with the conventional method of cleaning the surfaces of all substrates at a time by ion beam irradiation to the whole surface of the substrate holder, abrasion resistance of the oil repellent film to be obtained is improved.

### EXAMPLES

Next, the invention will be explained furthermore in detail by more specific examples of the embodiment of the present invention explained above.

### [Example 1]

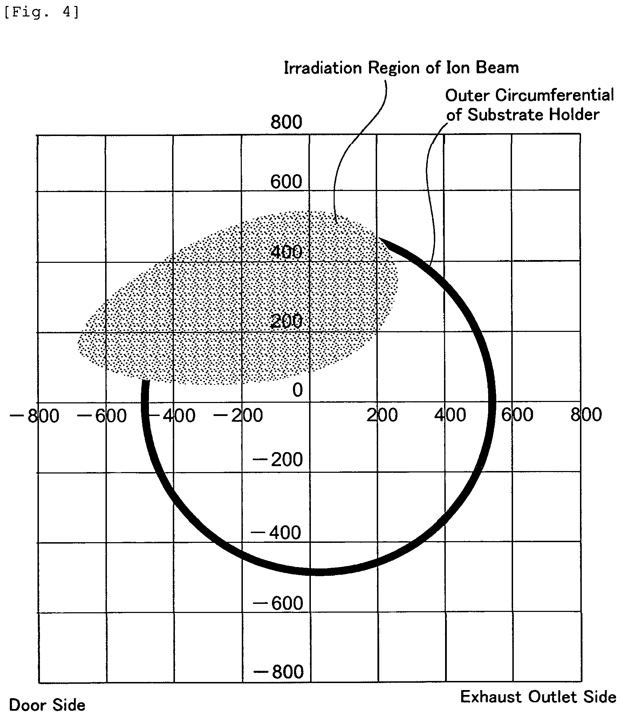

In the present example, the film deposition system 1 shown in FIG. 1 is prepared and oil repellent substrate samples were obtained by depositing films under the condition below. Note that a positional relationship of an irradiation region (A2) of an ion beam of the present example with the substrate holder 12 is shown in FIG. 4.

BK7 (refractive index "n" = 1.52) was used as a substrate and a rotation speed (RS) of the substrate holder was 30rpm.

As to the ion irradiation, a substrate temperature at the time of starting the irradiation was 100°C and a condition of the ion source was as below. In the present example, irradiation time (T2) of the ion beam per one substrate was 180 seconds.
* introduced gaseous species and introduced amount: O₂ for 50sccm
* ion accelerating voltage: 1000V
* irradiation ion current: 500mA
* irradiation time of ion beam to substrate holder: 300 seconds

As to depositing of an oil repellent film, a substrate temperature at starting the irradiation was 100°C and a condition of the film deposition was as below.
* film deposition material: oil repellent agent made by Canon Optron Inc. (product name: OF-SR, component name: fluorine-containing organic silicon compound)
* film deposition time (T1): 500 seconds

### < Evaluation of Abrasion Resistance >

On a surface of the oil repellent film of an obtained oil repellent substrate sample, 1cm² of steel wool #0000 was placed and an abrasion test was performed in a state of imposing a load of 1kg/cm² and at a speed of sliding back and forth for one time in 1 second on a 50mm straight line. After every 100 times of sliding back and forth of the abrasion test, a line was drawn with an oil marker pen (organic solvent type marker, product name: Mckee Extra Fine made by ZEBRA Co., Ltd.) on the tested surface (the oil repellent film surface) and it was evaluated whether the organic solvent type ink of the oil marker pen could be wiped off with a dry cloth or not. The result was that the maximum number of back-and-forth abrasion sliding at which the organic solvent type ink could be wiped off was 2200.

### < Evaluation of Water Contact Angle >

On a surface of the oil repellent film of an obtained oil repellent substrate sample, 1cm² of steel wool #0000 was placed and an abrasion test was performed in a state of imposing a load of 1kg/cm² and at a speed of sliding back and forth for one time in 1 second on a 50mm straight line for 5000 times. After that, a contact angle of water on the oil repellent film was measured by a method based on the wettability test of JIS-R3257. Specifically, an oil repellent substrate sample was placed on a test board, distilled water was dropped on the oil repellent film side after abrasion, and a contact angle of the water drop was measured optically in a static state. The result was 105 degrees.

### [Example 2]

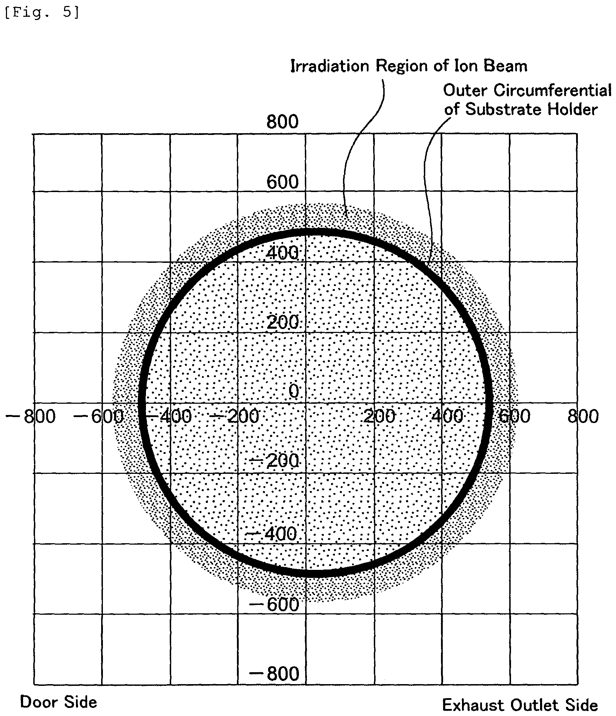

A conventional film deposition system (illustration is omitted) was prepared, wherein a region supplied with a film deposition material from a deposition source and an irradiation region of an ion beam from the ion source are the same on the substrate set surface of a substrate holder. By using this film deposition system, an oil repellent substrate sample was obtained by depositing a film under the same condition as that in the example 1. Note that a positional relationship of an irradiation region (A1) of the ion beam of the present example with the substrate holder 12 is shown in FIG. 5.

Note that irradiation time (T2) of the ion beam for one substrate was same as the irradiation time of the ion beam to the substrate holder: 300 seconds.

The maximum number of back-and-forth abrasion sliding on the oil repellent film of the obtained oil repellent substrate sample was 1100, and it was confirmed that the abrasion resistance was inferior to that of the sample of the example 1. However, even "the maximum number of back-and-forth abrasion sliding: 1100", the abrasion resistance was considered to be sufficient and good enough for practical use.

When measuring a contact angle of water on the oil repellent surface of the oil repellent substrate sample after abrasion in the same way, it was 40 degrees. Comparing with that of the sample of the example 1, the contact angle of water after abrasion was declined, and deterioration of abrasion resistance was confirmed.

## Claims

1. A method for depositing a film, comprising the steps of:
irradiating ions to a partial region of a lower surface of a substrate holder (12), thereby, the ions are irradiated only to a certain group fed to the region among a plurality of substrates (14) held on the lower surface and rotating; and
subsequently, in a state of suspending irradiation of the ions, supplying a film deposition material of an oil repellent film to all the substrates (14) by supplying the film deposition material to the whole region on the lower surface of the substrate holder (12), thereby depositing the oil repellent film on surfaces of the substrates (14).

2. The method for depositing a film according to claim 1, wherein when time of supplying the film deposition material is T1 and an irradiation time of ions is T2, ions are irradiated so as to satisfy T2 ≤ (1/2)xT1 for each substrate (14).

3. The method for depositing a film according to claim 1 or 2, wherein when a region supplied with the film deposition material is A1 and an ion irradiation region is A2, ions are irradiated to the lower surface of the substrate holder (12) so as to satisfy A2 ≤ (1/2)×A1.

4. The method for depositing a film according to any one of claims 1 to 3, wherein ions are irradiated so that an irradiation region becomes a region surrounded by a longitudinal closed curve along a moving direction of the substrates (14).

5. The method for depositing a film according to any one of claims 1 to 4, wherein ions having an accelerating voltage of 50 V to 1500 V are used.

6. The method for depositing a film according to any one of claims 1 to 5, wherein ions having an irradiation ion current of 50 mA to 1500 mA are used.

7. The method for depositing a film according to any one of claims 1 to 6, wherein ions containing at least oxygen are used.

8. A film deposition system (1) for depositing an oil repellent film wherein a substrate holder (12) having a lower surface for holding a plurality of substrates (14) is provided rotatably in a vacuum container (10), comprising:
an ion irradiation means (38) provided to inside the vacuum container (10) to have a configuration and in an arrangement and/or a direction, by which ions can be irradiated only to a partial region on the lower surface of the substrate holder (12); and
a film deposition means (34) provided in the vacuum container (10) in an arrangement and direction, by which a film deposition material can be supplied to allover the lower surface of the substrate holder (12);
**characterised by** a controller (52) configured to stop an operation of the ion irradiation means (38) before starting an operation of the film deposition means (34) so that the complete film deposition material is supplied in a state of suspended ion irradiation.

9. The film deposition system (1) according to claim 8, wherein the ion irradiation means (38) is provided to inside the vacuum container (10) in an arrangement, by which ions can be irradiated half or less of the whole region of the lower surface of the substrate holder (12).

10. The method for depositing a film according to any one of claims 1 to 7, or the film deposition system (1) according to claim 8 or 9, wherein the film deposition material is obtained by:
(a) impregnating a porous ceramic with a hydrophobic reactive organic compound; or
(b) impregnating a bundle of metal fibers or thin lines with a hydrophobic reactive organic compound.

## Patentansprüche

1. Verfahren zum Aufbringen eines Films, wobei in den Schritten des Verfahrens:
Ionen auf eine Teilregion einer unteren Fläche eines Substrathalters (12) gestrahlt werden, wodurch die Ionen nur auf eine bestimmte, in der Region angebrachte Gruppe unter mehreren Substraten (14) gestrahlt werden, die auf der unteren Fläche gehalten wird und rotiert, und
nacheinander, in einem Zustand der Unterbrechung der lonenbestrahlung, ein Filmaufbringungsmaterial eines ölabweisenden Films auf alle die Substrate (14) aufgebracht wird, indem das Filmaufbringungsmaterial der gesamten Region auf der unteren Fläche des Substrathalters (12) zugeführt wird, wodurch der ölabweisende Film auf Flächen der Substrate (14) aufgebracht wird.

2. Verfahren zum Aufbringen eines Films nach Anspruch 1, wobei, wenn die Zeit zum Zuführen des Filmaufbringungsmaterials T1 ist und eine Bestrahlungszeit der Ionen T2 ist, Ionen so gestrahlt werden, dass für jedes Substrat (14) T2 ≤ (1/2)xT1 erfüllt ist.

3. Verfahren zum Aufbringen eines Films nach Anspruch 1 oder 2, wobei, wenn eine mit dem Filmaufbringungsmaterial beschickte Region A1 ist und eine lonenbestrahlungsregion A2 ist, Ionen so auf die untere Fläche des Substrathalters (12) gestrahlt werden, dass A2 ≤ (1/2)xA1 erfüllt ist.

4. Verfahren zum Aufbringen eines Films nach einem der Ansprüche 1 bis 3, wobei Ionen so gestrahlt werden, dass eine Bestrahlungsregion eine Region wird, die durch eine longitudinal geschlossene Kurve längs einer Bewegungsrichtung des Substrats (14) umgeben ist.

5. Verfahren zum Aufbringen eines Films nach einem der Ansprüche 1 bis 4, wobei Ionen mit einer Beschleunigungsspannung von 50 V bis 1500 V verwendet werden.

6. Verfahren zum Aufbringen eines Films nach einem der Ansprüche 1 bis 5, wobei Ionen mit einem Bestrahlungsionenstrom von 50 mA bis 1500 mA verwendet werden.

7. Verfahren zum Aufbringen eines Films nach einem der Ansprüche 1 bis 6, wobei Ionen verwendet werden, die wenigstens Sauerstoff enthalten.

8. Filmaufbringungssystem (1) zum Aufbringen eines ölabweisenden Films, wobei ein Substrathalter (12) mit einer unteren Fläche zum Halten mehrerer Substrate (14) drehbar in einem Vakuumbehälter (10) vorgesehen ist, mit
einer lonenbestrahlungseinrichtung (38), die im Innern des Vakuumbehälters (10) vorgesehen ist, so dass sie eine Konfiguration hat und in einer Anordnung und/oder einer Richtung gebildet ist, durch welche Ionen nur auf eine Teilregion auf der unteren Fläche des Substrathalters (12) gestrahlt werden können, und
einer Filmaufbringungseinrichtung (34), die in dem Vakuumbehälter (10) in einer Anordnung und Richtung vorgesehen ist, durch welche ein Filmaufbringungsmaterial der gesamten unteren Fläche des Substrathalters (12) zugeführt werden kann,
**gekennzeichnet durch** eine Steuereinheit (52), die dazu konfiguriert ist, einen Betrieb der lonenbestrahlungseinrichtung (38) zu unterbrechen, bevor ein Betrieb der Filmaufbringungseinrichtung (34) gestartet wird, so dass das gesamte Filmaufbringungsmaterial in einem Zustand unterbrochener lonenbestrahlung zugeführt wird.

9. Filmaufbringungssystem (1) nach Anspruch 8, wobei die lonenbestrahlungseinrichtung (38) im Innern des Vakuumbehälters (10) in einer Anordnung vorgesehen ist, durch welche Ionen höchstens auf die Hälfte der gesamten Region der unteren Fläche des Substrathalters (12) gestrahlt werden können.

10. Verfahren zum Aufbringen eines Films nach einem der Ansprüche 1 bis 7, oder Filmaufbringungssystem (1) nach Anspruch 8 oder 9, wobei das Filmaufbringungsmaterial erhalten ist durch:
(a) Tränken einer porösen Keramik mit einer hydrophoben, reaktiven, organischen Verbindung, oder
(b) Tränken eines Bündels von Metallfasern oder dünnen Leitungen mit einer hydrophoben, reaktiven, organischen Verbindung.

## Revendications

1. Procédé de dépôt d'un film, comprenant les étapes de :
irradiation d'ions sur une région partielle d'une surface inférieure d'un porte-substrats (12), ainsi, les ions ne sont irradiés que sur un certain groupe alimenté sur la région parmi une pluralité de substrats (14) maintenus sur la surface inférieure et rotatifs ; et
ensuite, dans un état d'interruption d'irradiation des ions, alimentation d'un matériau de dépôt de film d'un film oléofuge sur tous les substrats (14) en alimentant le matériau de dépôt de film sur la totalité de la région sur la surface inférieure du porte-substrats (12), déposant ainsi le film oléofuge sur des surfaces des substrats (14).

2. Procédé de dépôt d'un film selon la revendication 1, dans lequel, lorsqu'un temps d'alimentation du matériau de dépôt de film est T1 et un temps d'irradiation d'ions est T2, des ions sont irradiés de manière à satisfaire à T2 ≤ (1/2)xT1 pour chaque substrat (14).

3. Procédé de dépôt d'un film selon la revendication 1 ou 2, dans lequel, lorsqu'une région alimentée avec le matériau de dépôt de film est A1 et une région d'irradiation d'ions est A2, des ions sont irradiés sur la surface inférieure du porte-substrats (12) de manière à satisfaire à A2 ≤ (1/2)xA1.

4. Procédé de dépôt d'un film selon l'une quelconque des revendications 1 à 3, dans lequel des ions sont irradiés de telle manière qu'une région d'irradiation devient une région entourée par une courbe longitudinale fermée le long d'un sens de déplacement des substrats (14).

5. Procédé de dépôt d'un film selon l'une quelconque des revendications 1 à 4, dans lequel des ions ayant une tension d'accélération de 50 V à 1 500 V sont utilisés.

6. Procédé de dépôt d'un film selon l'une quelconque des revendications 1 à 5, dans lequel des ions ayant un courant ionique d'irradiation de 50 mA à 1 500 mA sont utilisés.

7. Procédé de dépôt d'un film selon l'une quelconque des revendications 1 à 6, dans lequel des ions contenant au moins de l'oxygène sont utilisés.

8. Système (1) de dépôt de film pour déposer un film oléofuge dans lequel un porte-substrats (12) ayant une surface inférieure pour maintenir une pluralité de substrats (14) est prévu rotatif dans un récipient sous vide (10), comprenant :
un moyen (38) d'irradiation d'ions prévu à l'intérieur du récipient sous vide (10) pour avoir une configuration et dans un agencement et/ou un sens, par lequel des ions ne peuvent être irradiés que sur une région partielle sur la surface inférieure du porte-substrats (12) ; et
un moyen (34) de dépôt de film prévu dans le récipient sous vide (10) dans un agencement et un sens, par lequel un matériau de dépôt de film peut être alimenté sur la totalité de la surface inférieure du porte-substrats (12) ;
**caractérisé par** un contrôleur (52) configuré pour stopper un fonctionnement du moyen (38) d'irradiation d'ions avant le début d'un fonctionnement du moyen (34) de dépôt de film de telle manière que la totalité du matériau de dépôt de film est alimentée dans un état d'irradiation d'ions interrompue.

9. Système (1) de dépôt de film selon la revendication 8, dans lequel le moyen (38) d'irradiation d'ions est prévu à l'intérieur du récipient sous vide (10) dans un agencement, par lequel des ions peuvent être irradiés sur la moitié ou moins de la totalité de la région de la surface inférieure du porte-substrats (12).

10. Procédé de dépôt d'un film selon l'une quelconque des revendications 1 à 7, ou système (1) de dépôt de film selon la revendication 8 ou 9, dans lequel le matériau de dépôt de film est obtenu par :
(a) imprégnation d'une céramique poreuse avec un composé hydrophobe réactif organique ; ou
(b) imprégnation d'un faisceau de fibres ou de lignes minces métalliques avec un composé hydrophobe réactif organique.
